# EUROPEAN PATENT SPECIFICATION

(11) **EP 2 178 116 B1**
(45) Date of publication and mention of the grant of the patent: **17.10.2012**
(21) Application number: 08827123.4
(22) Date of filing: 05.08.2008
(51) Int. Cl.: H01L 23/14, H05K 3/46, H01L 23/12, H01L 23/15, H01L 23/32, H05K 1/02

(54) **IC MOUNTING SUBSTRATE AND METHOD FOR MANUFACTURING THE SAME**
IC-MONTAGESUBSTRAT UND HERSTELLUNGSVERFAHREN DAFÜR
SUBSTRAT DE MONTAGE DE CIRCUIT INTÉGRÉ ET PROCÉDÉ POUR SA FABRICATION

(30) Priority: 08.08.2007 US 954671 P; 21.04.2008 US 106723
(43) Date of publication of application: 21.04.2010
(73) Proprietor: Ibiden Co., Ltd., Gifu 503-0917 (JP)
(72) Inventor: TANAKA, Hironori, Ibi-gun Gifu 501-0695 (JP); KAWANO, Shuichi, Ibi-gun Gifu 501-0695 (JP)
(74) Representative: HOFFMANN EITLE
(86) International application number: PCT/JP2008/064049
(87) International publication number: WO 2009/020124

(56) References cited:
- WO-A1-2006/070807
- JP-A- 2005 223 226
- JP-A- 2007 027 337
- US-A1- 2005 136 634
- US-A1- 2005 263 867
- US-B1- 6 775 150

## Description

### Technical Field:

The present invention relates to a substrate for mounting an IC chip applicable to a package substrate onto which an IC chip is mounted.

### Background Technology:

An IC chip and a package substrate have conventionally been connected with an interposer being interposed. An interposer is connected to the pads located on the outermost layer of the package substrate through solder bumps. Patent Document 1 discloses a semiconductor integrated circuit device wherein a 4-layer wiring interposer is attached to the pads of a rough-pitch substrate through solder bumps. Further, Patent Document 2 discloses a packaging substrate with an intermediate substrate made from bis-maleimide triazine, for example, in order to overcome differences in the coefficient of thermal expansion. An intermediate substrate for the same purpose is taught by Patent Document 3. This intermediate substrate is made of a polymeric material and includes a substrate core and a ceramic sub-core section. Patent Document 4 discloses a substrate with an extension board, which are connected via solder resists. Moreover, Patent Document 5 teaches a composite multilayer substrate with a ceramic multilayer substrate and a resin laminate having different expansion coefficients from each other. Further, Patent Document 6 discloses a method for manufacturing a wiring board having a structure in which a ceramic dielectric layer and a polymer dielectric layer are composite laminated and a corresponding wiring board capable of increasing the adhering strength between layers while being hard to cause a problem such as peeling at the time of reflow process or the like.
Patent Document 1:
   Laid-open patent 2001-102479 gazette
Patent Document 2:
   US 2005/0136634 A1
Patent Document 3:
   US 2005/0263867 A1
Patent Document 4:
   JP 2007/027337 A
Patent Document 5:
   JP 2005/223226 A
Patent Document 6:
   WO 2006/070807 A1 I

### Disclosure of the Invention:

### Problem to be solved by the Invention:

However, since the conventional technology is such that the connection between the interposer and the package substrate is made through solder bumps made of a high resistant solder, there occurs a large voltage drop on account of the solder bumps when the IC chip mounted on said interposer instantaneously consumes a large electrical power, resulting in a difficulty of maintaining the voltage value over a certain range and in causing the IC chip to malfunction due to the voltage drop.

Further, the mounting of an interposer onto a package substrate required complex operations such as aligning the solder bumps on the interpose side and the connecting pads of the package substrate, reflowing, underfill filling, etc.

The present invention has been brought about to solve the above-described issues, and the purpose therefore is to provide a substrate for mounting an IC chip having a low electrical resistance with a built-in inorganic substrate.

### Means to solve the Problem:

For achieving the above-described purpose, the technical characteristics of the substrate for mounting an IC chip as set forth in claim 1 are set forth such that it comprises: a printed substrate 100 having the first build-up layer 37 wherein a conductor layer having the first conductor circuit 35 and a resin insulating layer 34 are laminated in an alternate fashion and in repetition;
a low-elasticity resin layer 60 formed, wherein a Young's modulus of the low-elasticity resin layer at 30 °C is 10 MPa through 1 GPa, on one face of said printed substrate 100, on the conductor layer 35 and the resin insulating layer 34 positioned on the outermost layer of the above-described first build-up layer 37;
a low-thermal-expansion substrate 62 formed of ceramics or silicon and formed on said low-elasticity resin layer 60;
a through-hole conductor 74 running through said low-thermal-expansion substrate 62 and the above-described low-elasticity resin layer 60; and
the second conductor circuit 75 formed on one face of the above-described low-thermal-expansion substrate 62,
wherein the above-described through-hole conductor 74 being a through-hole filled by plating electrically connects the conductor layer 35 positioned on the outermost layer of the above-described first build-up layer and the second conductor circuit 75 on the above-described low-thermal-expansion substrate 62 without soldering.

And, the technical characteristics of the method for manufacturing the substrate for mounting an IC chip as set forth in claim 9 are set forth such that they comprise the following (a) through (f) steps:
(a) a step for laminating a low-thermal-expansion substrate with a low-elasticity resin layer being interposed on the printed substrate having conductor pads for mounting on the outermost layer thereof, wherein a Young's modulus of the low-elasticity resin layer (60) at 30 °C is 10 MPa through 1 GPa;
(b) a step for boring the first through holes running through the above-described low-thermal-expansion substrate and the above-described low-elasticity resin layer and reaching the above-described conductor pads for mounting;
(c) a step for filling insulating layers inside the above-described through holes;
(d) a step for boring the second through holes running through the above-described insulating layers inside the above-described through holes and reaching the above-described conductor pads for mounting;
(e) a step for forming through-hole conductors by providing plated layers inside the above-described second through holes; and
(f) a step for forming build-up wiring layers on the above-described low-thermal-expansion substrate.

### Effect of the Invention:

The substrate for mounting an IC chip as set forth in claim 1 is in particular set forth such that a low-thermal-expansion substrate is provided with a low-elasticity resin layer being interposed on the first build-up layer of the printed substrate and that the second conductor circuit is provided on said low-thermal-expansion substrate. The conductor pads of the printed substrate and the second conductor circuits are connected by the through-hole conductors formed in the through holes of the low-thermal-expansion substrate. As the connection to interpose a low-thermal-expansion substrate is made through the through-hole conductors without the use of soldering, the electrical resistance of the internal wiring is low. Accordingly, the power is smoothly supplied to the IC chip to be mounted, resulting in the power drop at the substrate for mounting an IC chip being small even when the IC chip consumes a large amount of power instantaneously, allowing the voltage value over a certain range to be maintained, and allowing the IC chip to be prevented from malfunctioning. And, as it does not use soldering, it requires no complex operations such as alignment for reflowing, reflowing, underfill filling, etc., allowing the manufacture thereof to be simplified. Further, on account of the use of a ceramic or silicon low-thermal-expansion substrate, the yield can be improved as it is smooth and the dielectric can easily be formed when a thin film capacitor is formed on said low-thermal-expansion substrate. Further, since it is possible for a thin-film capacitor to be formed first on the low-thermal-expansion substrate by sintering and then to be attached to the printed substrate, substrates for mounting an IC chip may be manufactured by attaching only conforming items following sintering to printed substrates irrespective of the yield of the capacitor. Further, since a low-thermal-expansion substrate is attached on the outermost layer of the printed substrate with a low-elasticity resin layer interposed, the stress generated by the difference in thermal expansion coefficient between the printed substrate and the low-thermal-expansion substrate may be absorbed by said low-elasticity resin layer which can prevent the occurrence of internal wire breakage, etc.

The substrate for mounting an IC chip as set forth in claim 2 is set forth such that a low-thermal-expansion substrate is provided with a low-elasticity resin layer being interposed on the first build-up layer of the printed substrate and that the second build-up wiring layer is provided on said low-thermal-expansion substrate. The conductor pads of the first build-up layer of the printed substrate and the second build-up wiring layer are connected by the through-hole conductors formed in the through holes of the low-thermal-expansion substrate. As the connection to interpose a low-thermal-expansion substrate is made through said through-hole conductors without the use of soldering, the electrical resistance of the internal wiring is low. Accordingly, the power is smoothly supplied to the IC chip to be mounted, resulting in the power drop at the substrate for mounting an IC chip being small even when the IC chip consumes a large amount of power instantaneously, allowing the voltage value over a certain range to be maintained, and allowing the IC chip to be prevented from malfunctioning. And, since the second build-up wiring layer is provided on a ceramic or silicon smooth low-thermal-expansion substrate, through-hole conductors and a wiring layer (circuit wiring) may be formed in fine pitch.

In claim 3, the pitch of the conductor layer (pad) for connecting an IC chip positioned on the outermost layer of the second build-up layer is narrower than the pitch of the through-hole conductors. Accordingly, the pins of an IC chip having a fine pitch may be fanned out and connected to a substrate such as a daughter board having a wider pitch.

In the substrate for mounting an IC chip in claim 4, since the pitch of the conductor layer positioned at the lowermost layer of the second build-up layer is nearly identical to the pitch of the through-hole conductors, through-hole conductors may most efficiently be placed as pertains to a fixed area.

In the substrate for mounting an IC chip in claim 5, since the diameter of the through-hole conductors of the low-thermal-expansion substrate is smaller than the diameter of the conductor pads of the second conductor circuit of the low-thermal-expansion substrate, a smaller diameter of the through holes prevents the occurrence of cracks in the thin low-thermal-expansion substrate.

In the substrate for mounting an IC chip in claim 6, since the-thermal-expansion substrate is made of silicon, the strength of the-thermal-expansion substrate can be maintained even when it is made thin, and, the length of the internal wiring can be made shorter by the thickness of the substrate for mounting an IC chip being made thinner.

In the substrate for mounting an IC chip in claim 7, since the low-elasticity resin layer is made of at least one composition selected from a group of resin compositions including epoxy resin, phenol resin, crosslinking rubber particles and hardening catalyst, the CTE of the low-elasticity resin layer can easily be adjusted to 50 ppm or lower.

Since Young's modulus of the low-elasticity resin layer of the substrate for mounting an IC chip in claim 1 at 30°C is 10 MPa through 1 GPa, the stress generated by the difference in thermal expansion coefficient between the printed substrate and the low-thermal-expansion substrate may be absorbed by said low-elasticity resin layer which can prevent the occurrence of internal wire breakage, etc.

In a substrate for mounting an IC chip as set forth in claim 8, on the low-thermal-expansion substrate there is provided at least one of the passive elements such as an L, a C, an R, and a VRM. Since it is possible for it to be formed first on the low-thermal-expansion substrate by sintering and then to be attached to the printed substrate, substrates for mounting an IC chip may be manufactured by attaching only conforming items following sintering to printed substrates irrespective of the yield of the passive element.

] In a substrate for mounting an IC chip as set forth in claim 9, the first through holes running through the low-thermal-expansion substrate and the low-elasticity resin layer and reaching the conductor pads for mounting of the printed substrate are bored. The insulating layers are filled inside the through holes, and the second through holes running through the insulating layers inside the through holes and reaching the conductor pads for mounting are bored. And, through-hole conductors are formed by providing a plated layer inside the second through holes. Accordingly, the conductor pads for mounting of the printed substrate and the build-up wiring layer can be connected by the through-hole conductors formed inside the through holes of the low-thermal-expansion substrate.

### Best Modes to Carry out the Invention:

### First Best Mode:

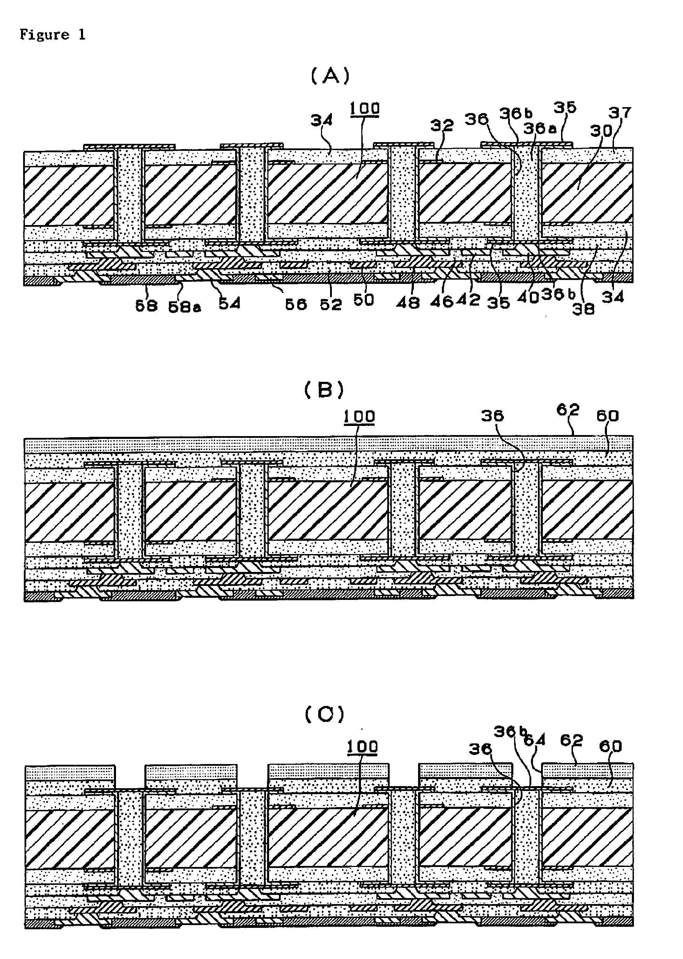

In the following, the substrate for mounting an IC chip pertaining to the first best mode in accordance with the present invention will be described with reference to Figs. 1 through 9.

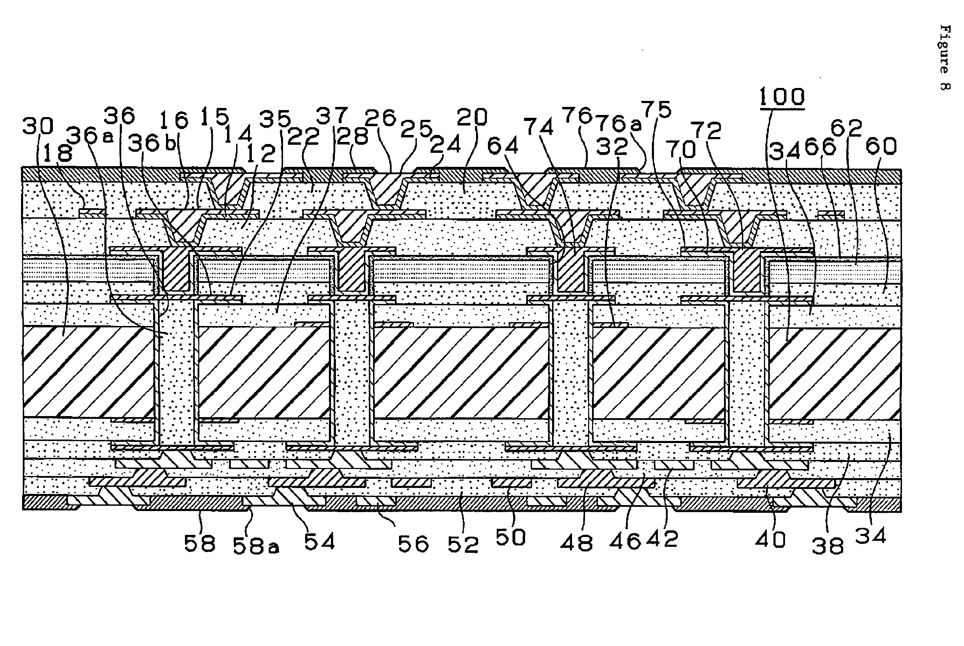

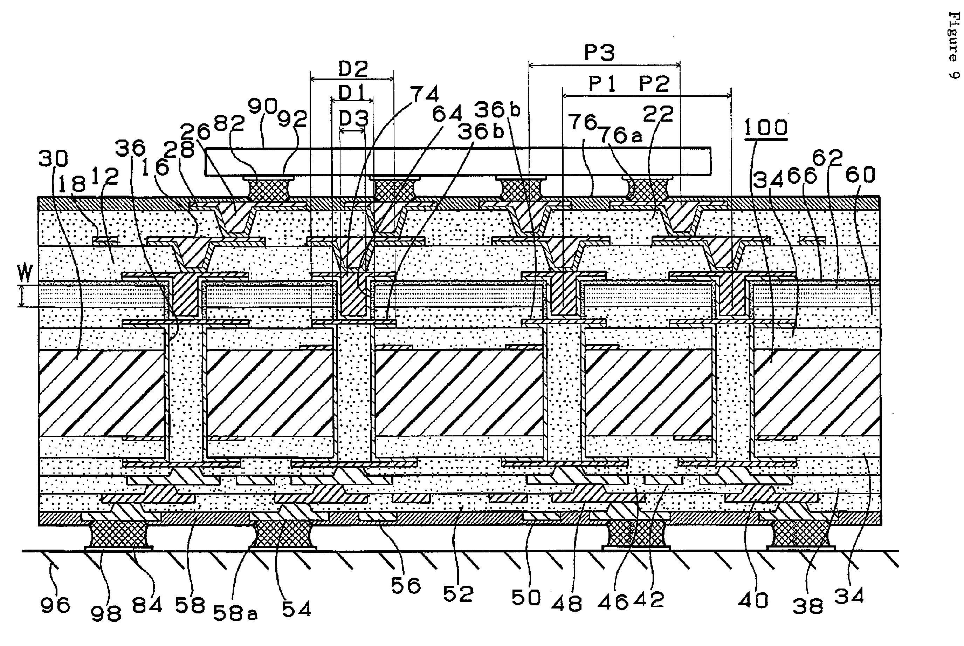

Fig. 1 (A) illustrates a cross-sectional view of a multilayer build-up wiring board 100 constituting a substrate for mounting an IC chip. Fig. 8 illustrates a cross-sectional view of a substrate for mounting an IC chip 10, and Fig. 9 a view wherein an IC chip is attached to the substrate for mounting an IC chip 10 illustrated in Fig. 8 which is disposed on the daughter board 96. As illustrated in Fig. 8, a substrate for mounting an IC chip 10 is set forth such that there is provided a silicon substrate 62 on the first build-up layer 37 of the multilayer build-up wiring board 100 illustrated in Fig. 1 (A) with the low-expansion resin layer 60 being interposed, and, that further, there is provided a interlaminar resin insulating layer 12 having a conductor circuit 18 on the silicon substrate 62, and that there is provided an interlaminar resin insulating layer 22 provided with a conductor circuit 28 on said interlaminar resin insulating layer 12. The interlaminar resin insulating layer 12 is connected via via-hole conductors 16 and the interlaminar resin insulating layer 22 is connected via via-hole conductors 26. The interlaminar resin insulating layer 12 having via-holes 16 and the conductor circuit 18 and the interlaminar resin insulating layer 22 provided with via-holes 26 and the conductor circuit 28 constitute the second build-up layer 20. On the upper layer of the interlaminar resin insulating layer 22 there is provided a solder resist layer 76, for example, and the conductor circuits 28 and the via-hole conductors 26 exposed at the openings 76a of the solder resist layer 76 constitute pads for mounting an IC chip 90.

As illustrated in Fig. 1 (A), the multilayer build-up wiring board 100 is formed with glass epoxy resin or BT (bis-maleimide triazine) resin wherein on the top and bottom faces of the core substrate 30 provided with a core and made of resin there are provided interlaminar resin insulating layers 34, 34 and through holes 36 running through the core substrate 30 and interlaminar resin insulating layers 34. On the surface of the core substrate 30 there are formed conductor circuits 32. Inside the through holes 36 resin 36a, for example, is filled, on both end portions lands 36b being formed, and the lands on the upper face constituting conductor pads for mounting 36b. On the interlaminar resin insulating layers 34 the first conductor circuits 35 are formed along with the conductor pads for mounting 36b. The interlanimar resin insulating layer 34, the conductor pads for mounting 36b, and the first conductor circuits 35 on the upper face side constitute the first build-up layer 37. On the outer layer of said interlaminar resin insulating layer 34 on the lower side, there is provided a interlaminar resin insulating layer 38 provided with conductor circuit 50 and via-holes 48, and on the outer layer of said interlaminar resin insulating layer 38, there is provided an interlaminar resin insulating layer 52 provided with conductor circuits 50 and via holes 48. On the outer layer of the interlaminar resin insulating layer 52, a solder resist layer 58, for example is provided, and the conductor circuits 50 and the via-holes 48 exposed by the openings 58a of the solder resist layer 58 constitute pads for connecting to the daughter board 96.

As illustrated in Fig. 9, the solder bumps 82 on the upper face side of the substrate for mounting an IC chip 10 are connected to the pads 92 of the IC chip 90. On the hand, the solder bumps 84 on the lower face side are connected to the pads 98 of the daughter board 96.

As illustrated in Fig. 8, the substrate for mounting an IC chip in accordance with the first best mode is set forth such that on the first build-up layer 37 of the multilayer build-up wiring board 100 with a low-expansion resin layer 60 being interposed and that the second build-up layer 20 is provided on said silicon substrate 62. The conductor pads for mounting 36b of the multilayer build-up wiring plate 100, the first conductor circuits 35, and the second build-up layer 20 are connected by the through-hole conductors 74 formed inside the through holes 64 of the silicon substrate 62. As the connection to interpose the silicon substrate 62 is made through the through-hole conductors 74 without the use of soldering, the electrical resistance of the internal wiring is low. Accordingly, the power is smoothly supplied to the IC chip 90 to be mounted, resulting in the power drop at the substrate for mounting an IC chip 10 being small even when the IC chip 90 consumes a large amount of power instantaneously, allowing the voltage value over a certain range to be maintained, and allowing the IC chip 90 to be prevented from malfunctioning.
And, as it does not use soldering, it requires no complex operations such as alignment for reflowing, reflowing, underfill filling, etc., allowing the manufacture thereof to be simplified.
And, since the second build-up layer 20 is provided on a smooth low-thermal-expansion substrate 62, the via-hole conductors 16, 26 and the wiring layers (circuit wiring) 18, 28 may be formed in fine pitch.
Further, since the silicon substrate 62 is attached on the outermost layer of the multilayer build-up wiring board 100 with a low-elasticity resin layer 60 interposed, the stress generated by the difference in thermal expansion coefficient between the multilayer build-up wiring board 100 (the core substrate 30) and the silicon substrate may be absorbed by said low-elasticity resin layer, which can prevent the occurrence of internal wire breakage, etc.

The substrate for mounting an IC chip 10 in accordance with the first best mode is set forth such that the use of a silicon substrate 62 made of silicon allows the silicon substrate 62 to be thin while maintaining strength and that the length of the internal wiring can be made shorter by the thickness of the substrate for mounting an IC chip 10 being made thinner. And, it can enhance the heat dissipation property thereof.

The substrate for mounting an IC chip 10 in accordance with the first best mode is set forth such that since there is provided an insulating layer 66 between the through holes 64 of the silicon substrate 62 and the through-hole conductors 74 provided inside said through holes 64, it can prevent the current to flow toward the side of the silicon substrate 62 being a semiconductor. And, it can ease with said insulating layer 66 the stress due to the difference in thermal expansion rate between the silicon substrate 66 and the through-hole conductors 74.

As illustrate in Fig. 9, the substrate for mounting an IC chip 10 in accordance with the first best mode is set forth such that the pitch P3 of the conductor layer (pad) for connecting an IC chip positioned on the outermost layer of the second build-up layer 20 is narrower than the pitch P1 of the through-hole conductor 74. Accordingly, the pads 92 of the IC chip 90 having a fine pitch may be fanned out and connected to the pads 98 of the daughter board 96 having a wider pitch.

As illustrate in Fig. 9, the substrate for mounting an IC chip 10 in accordance with the first best mode is set forth such that since the pitch P1 of the through-hole conductors of the silicon substrate 62 is identical to the pitch P2 of the conductor pads for mounting of the multilayer build-up wiring board 100, through-hole conductors 74 may most efficiently be placed as pertains to a fixed area.

The substrate for mounting an IC chip 10 in accordance with the first best mode is set forth such that the diameter D1 of the through-hole conductors 74 of the silicon substrate 62 is smaller than the diameter D2 of the conductor pads for mounting 36b of the multilayer build-up wiring board 100. Accordingly, a smaller diameter D3 of the through holes 64 can prevent the occurrence of cracks in the thin silicon substrate 62. In addition, a high connectivity between the through-hole conductors 76 and the pads 36b is secured.

The substrate for mounting an IC chip 10 in accordance with the first best mode is set forth such that the low-elasticity resin layer 60 is made of at least one composition selected from a group of resin compositions including epoxy resin, phenol resin crosslinking rubber particles and hardening catalyst (deformed amine, multifunctional phenol, imidazole, mercaptan, acid anhydride, etc.). Accordingly, the CTE of the low-elasticity resin layer 60 can easily be adjusted to 50 ppm or lower (preferably, 10 ppm or higher), and the stress generated by the difference in thermal expansion coefficient between the multilayer build-up wiring board 100 (the core substrate 30) and the silicon substrate 62 may be absorbed by said low-elasticity resin layer 60, which can prevent the occurrence of internal wire breakage, etc.

Young's modulus of the low-elasticity resin layer 60 of the substrate for mounting an IC chip in accordance with the first best mode at 30°C is set to be 10 MPa through 1 GPa. Accordingly, the stress generated by the difference in thermal expansion coefficient between the printed substrate 100 and the low-thermal-expansion substrate 62 may be absorbed by said low-elasticity layer 60, which can prevent the occurrence of internal wire breakage, etc.

To continue on, a method for manufacturing the above-described substrate for mounting an IC chip 10 with reference to Fig. 8 will be described with reference to Figs. 1-7.
(1) To the multilayer build-up wiring board 100 provided on the outermost layer on the upper face side with the first build-up layer 37 comprising the conductor pads for mounting (through-hole lands) 36b and the first conductor circuits 35, as illustrated in Fig. 1 (A), a silicon substrate 62 is adhered via a low-elasticity resin layer 60 (Fig. 1 (B)). Following this, the surface of the silicon substrate 62 may be ground such that it is smoothened. Accordingly, a build-up layer may easily be formed.

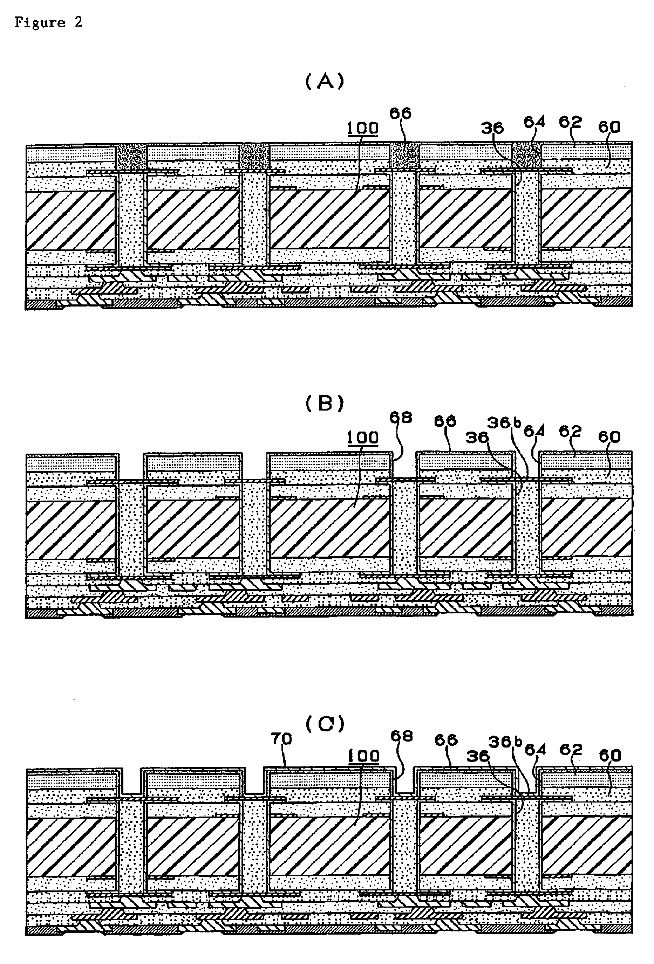

(2) Openings 64 reaching the conductor pads for mounting 36b are bored with laser into the silicon substrate 62 and the low-elasticity resin layer 60 (Fig. 1 (C)).
(3) Inside the openings 64 and on the surface of the silicon substrate 62 there is formed an insulating layer 66 made of resin (Fig. 2 (A)).
(4) Openings 68 reaching the conductor pads for mounting 36b are formed by laser in the insulating layers 66 inside the openings 64 (Fig. 2 (B)).
(5) On the surface of the silicon substrate 62 and on the insulating layers 66 inside the openings 68 there are formed electroless-plated films 70 by electroless plating (Fig. 2 (C)).

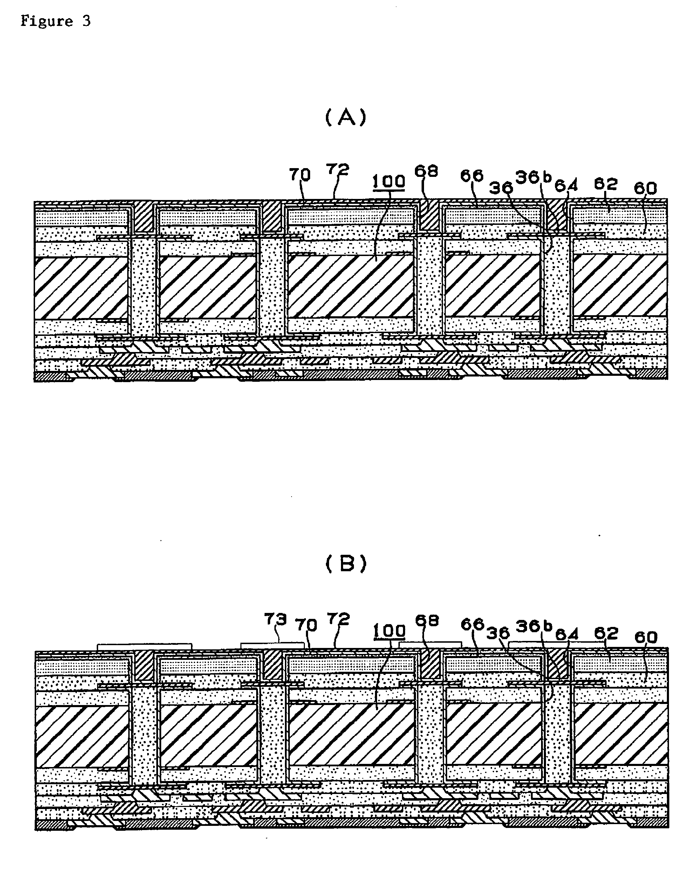

(6) Electrolysis is performed via the electroless-plated films 70 to fill the inside of the openings 68 with electrolysis plating 72 (Fig. 3 (A)).
(7) An etching resist 73 of a predetermined pattern is formed (Fig. 3 (B)).

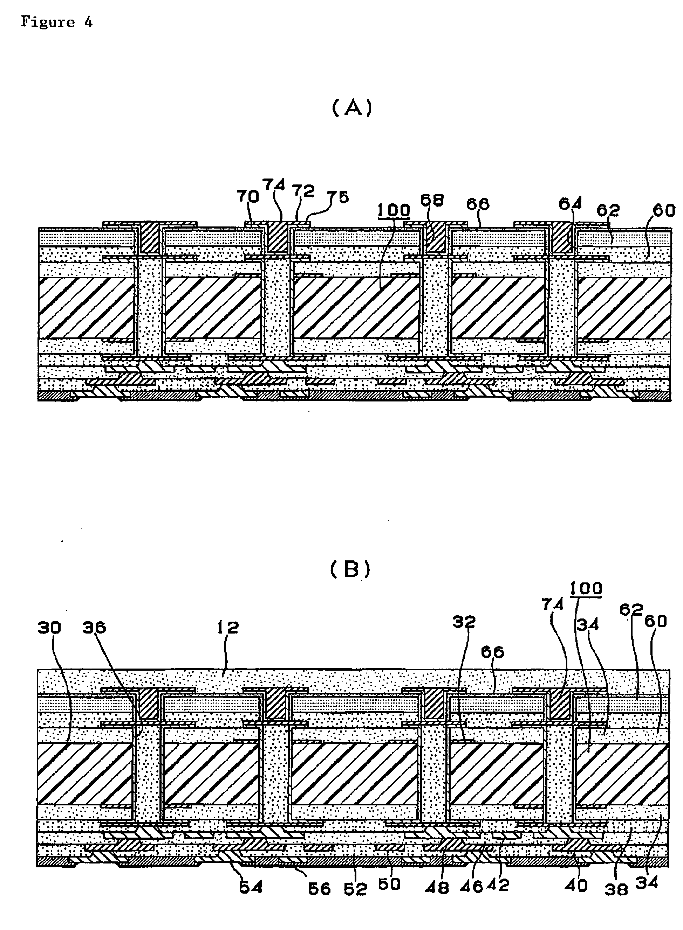

(8) After the electrolysis plating 72 and the electroless-plated films are removed by etching at the non-forming portions of the etching resist 73, the etching resist 73 is peeled off. This forms a through-hole conductors 74 providing conductivity from the top to the bottom of the silicon substrate 62 and the second conductor circuits 75 on the silicon substrate 62 (Fig.4 (A)).
(9) On the insulating layer 66 of the silicon substrate 62 there is formed an interlaminar resin insulating layer 12 (Fig. 4 (B)).

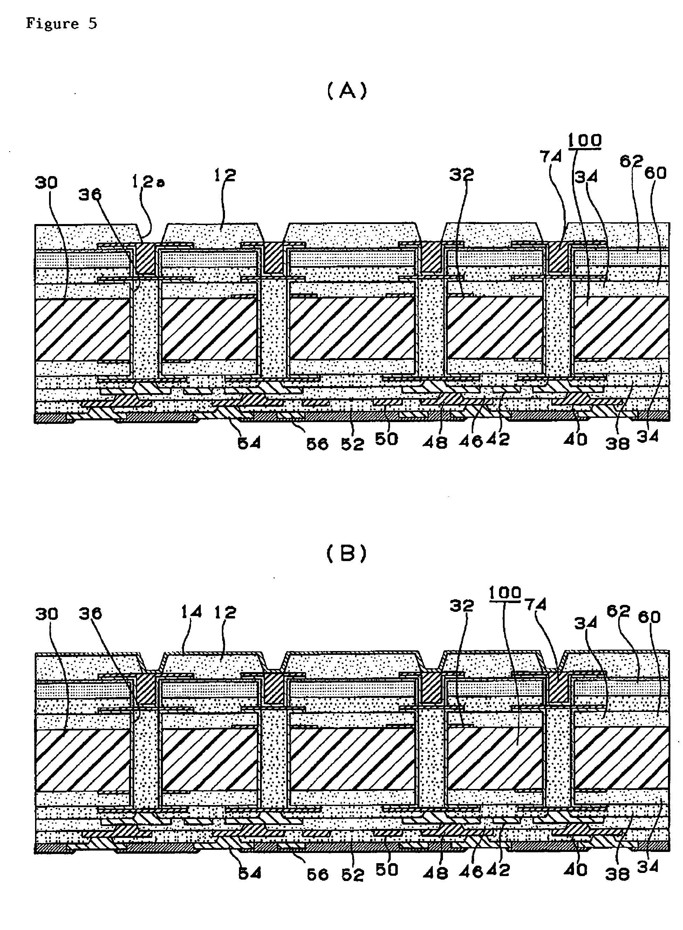

(10) Openings 12 reaching the through-hole conductors 74 are bored into the interlaminar resin insulating layer 12 with laser (Fig. 5 (A)).
(11) An electroless-plated film 14 is formed by electroless plating on the surface of the interlaminar resin insulating layer 12 and inside the openings 12a (Fig. 5 (B)).

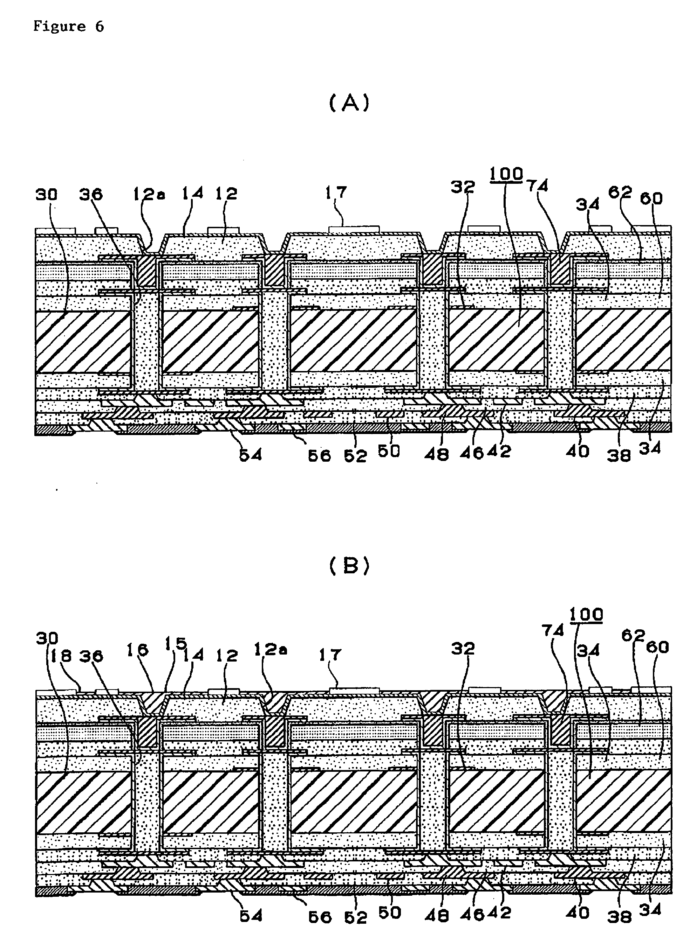

(12) A plated resist 17 of a predetermined pattern is formed (Fig. 6 (A)).
(13) An electrolysis plating 15 is formed via the electroless-plated film 14 on the non-formed portions of the plated resist 17 by electrolysis plating (Fig. 6 (B)).

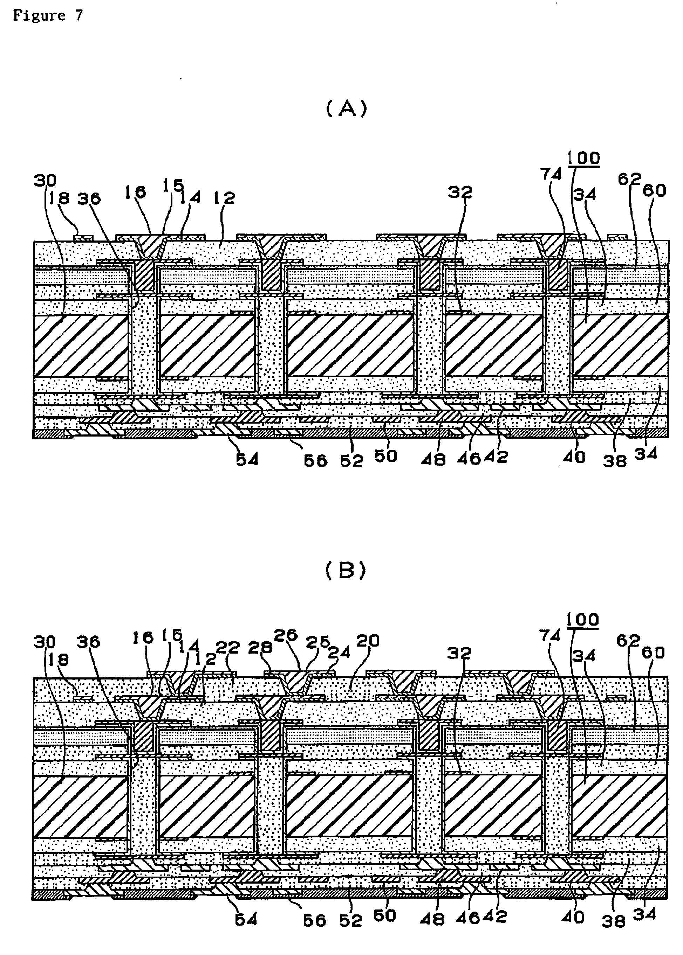

(14) The plated resist 17 is peeled off, and the electroless plated film 14 underneath the plated resist 17 is removed by light etching. This forms via-hole conductors 16 running through the interlaminar resin insulating layer 12 and conductor circuits 18 (Fig. 7 (A)).
(15) The above-described steps (3)-(14) are repeated to form on the interlaminar resin insulating layer 12 an interlaminar resin insulating layer 22 provided with via-hole conductors 26 and conductor circuits 28, completing the second build-up layer 20 comprising the interlaminar resin insulating layer 12 and the interlaminar resin insulating layer 22 (Fig. 7 (B)).

(16) A solder resist layer 76 provided with openings 76a on interlaminar resin insulating layers 22 is formed to manufacture a substrate for mounting an IC chip 10 (Fig. 8).

An IC chip 90 is disposed on the substrate for mounting an IC chip 10 and the connection pads of the printed wiring board and the pads 92 of the IC chip 90 are connected via solder bumps 82. Following this, it is attached to the pads 98 of the daughter board 96 via solder bumps 84 (Fig. 9).

### Modified Example of the First Best Mode:

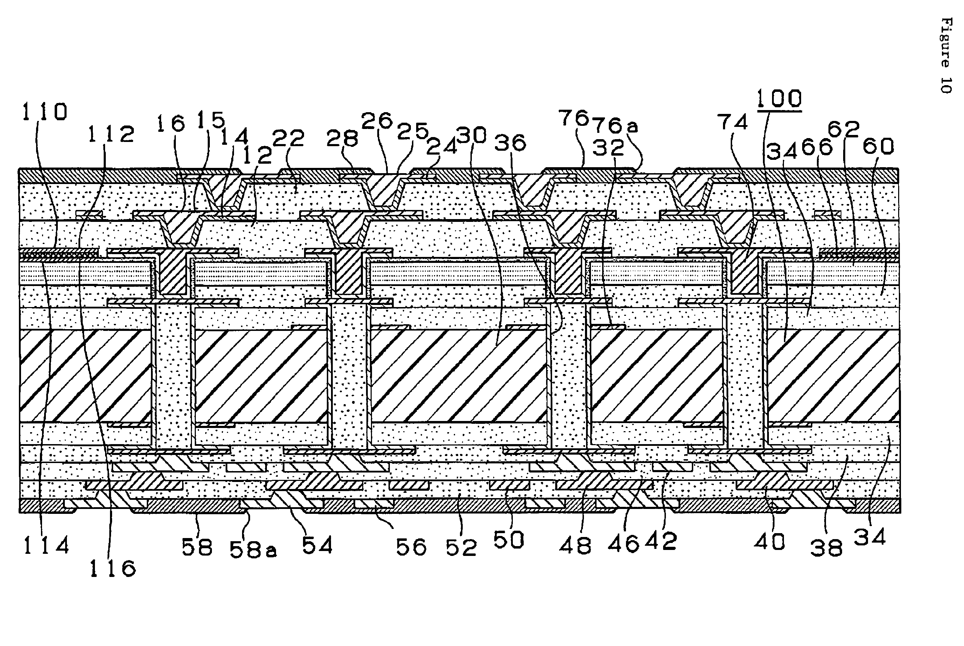

Fig. 10 is a cross-sectional view of a substrate for mounting an IC chip 10 pertaining to a modified example of the first best mode.
In the modified example of the first best mode, a thin film capacitor 110 formed by sintering is provided on the silicon substrate 62 of the substrate for mounting an IC chip 10. Said thin film capacitor 110 is set forth such that between electrode films 112, 114 there is disposed a dielectric film 116 made of ceramic and having a high dielectric constant.

In the modified example of the first best mode, the thin-film capacitor 110 is first formed by sintering on a silicon substrate 62 and then attached to the multilayer build-up wiring board 100. Accordingly, the substrate for mounting an IC chip 10 may be manufactured by attaching only conforming items following sintering to the multilayer build-up wiring board 100 irrespective of the yield of the capacitor. Further, when a thin film capacitor is formed on the silicon substrate 62, the silicon substrate 62 is smooth and a dielectric can easily be formed while the yield may be improved. In addition, in the modified example of the first best mode, while the capacitor is provided on the silicon substrate 62, it is possible, besides this, for it to be provided with a passive element such as L, R, VRM (voltage regulator model), to illustrate, along with a capacitor.

### Second Best Mode:

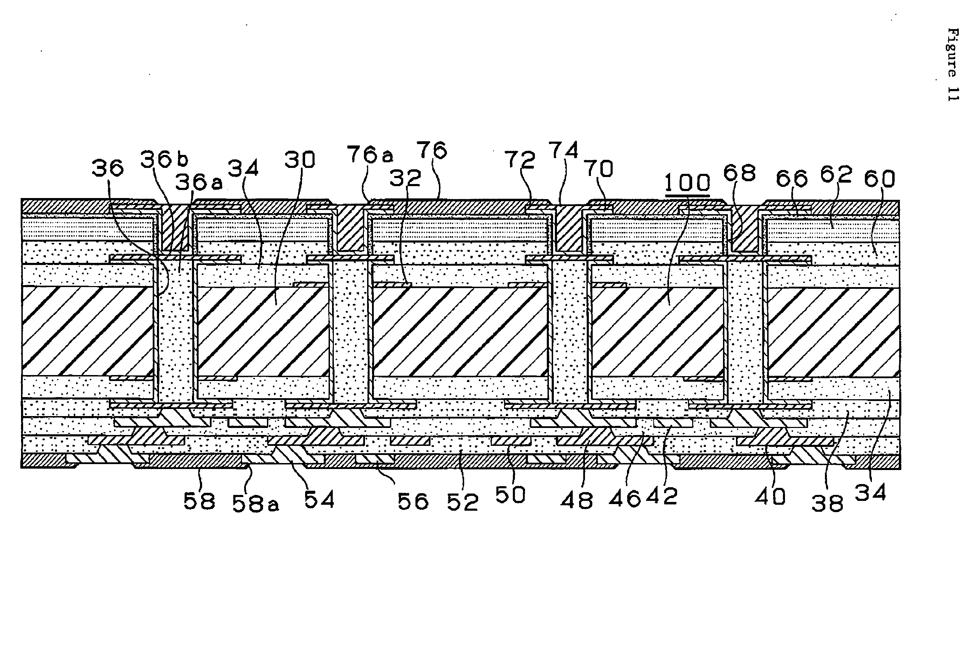

Fig. 11 is a cross-sectional view of the substrate for mounting an IC chip 10 in accordance with the second best mode.
In the above-described first best mode, on the silicon substrate 62 build-up wiring layers 12, 14, 16, 22, 24, and 26 were formed. As opposed to this, the constitution of the second best mode is such that the IC chip is directly connected to the through-hole conductors 74 without build-up wiring layers being provided.

### Third Best Mode:

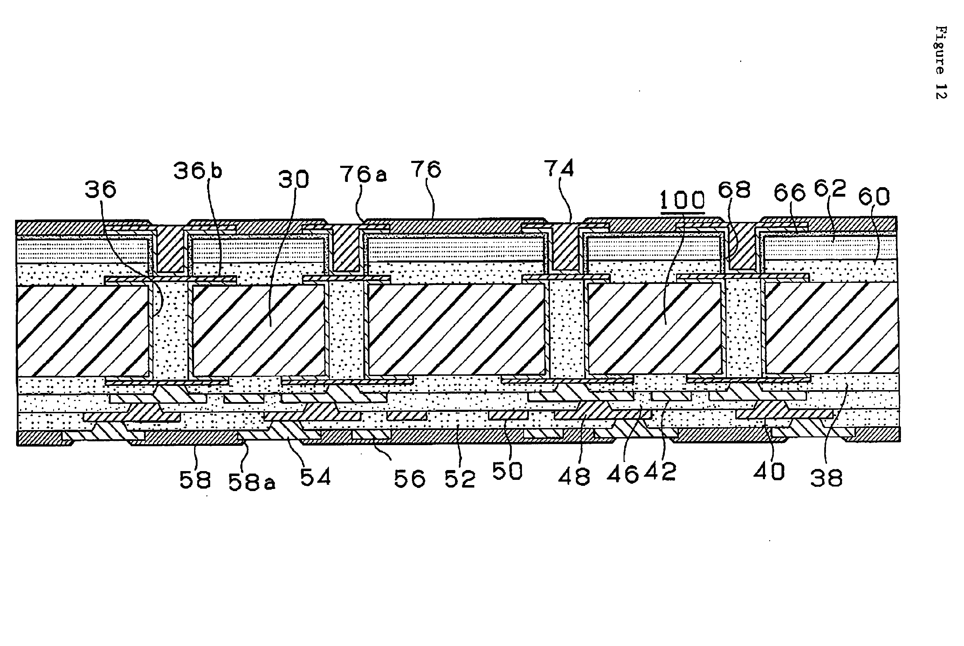

Fig. 12 is a cross-sectional view of a substrate for mounting an IC chip 10 in accordance with the third best mode.
The above-described first and second best modes were formed such that the through holes 36 ran through the core substrate 30 and interlaminar resin insulating layers 34. As oppose to this, the third best mode is such that the through holes 36 run through the core substrate 30, that lands (conductor pads for mounting) 36b are formed on said core substrate 30, and that to said lands 36b the through-hole conductors 74 of the silicon substrate 62 are connected.

### Fourth Best Mode:

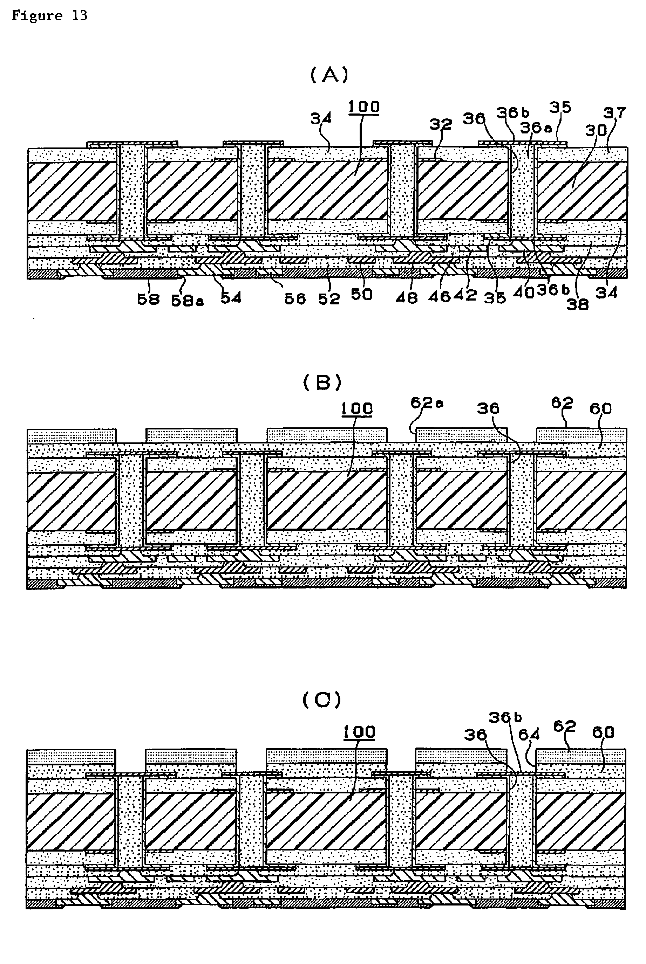

Continuing on, the method for manufacturing the substrate for mounting an IC chip pertaining to the fourth best mode in accordance with the present invention will be described with reference to Fig. 13. In the first through third best modes, through holes 64 were bored after the silicon substrate 62 was adhered to the low-elasticity resin layer 60. As opposed to this, in the fourth best mode, a silicon substrate 62 with via holes 62a having been formed in advance is adhered to the multilayer build-up wiring board 100 illustrated in Fig. 13 (A) (Fig. 13 (B)), and through holes 64 are bored into a low-elasticity resin layer 60 by laser via said via holes 62a (Fig. 13 (C)). The description of the subsequent steps is omitted since they are identical to those of the first best mode. The fourth best mode presents an advantage of an ease of processing.

### Fifth Best Mode:

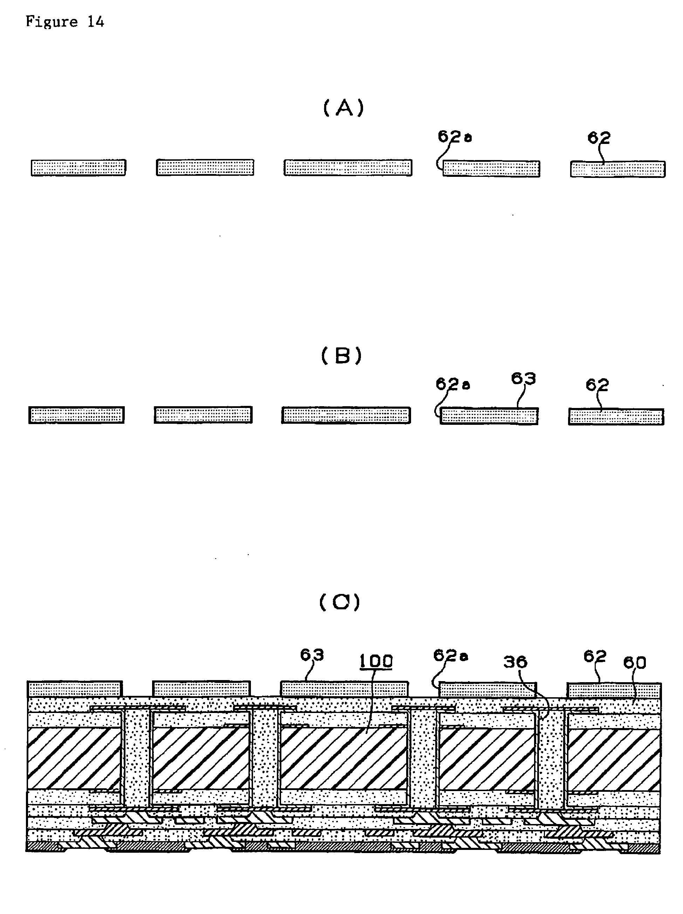

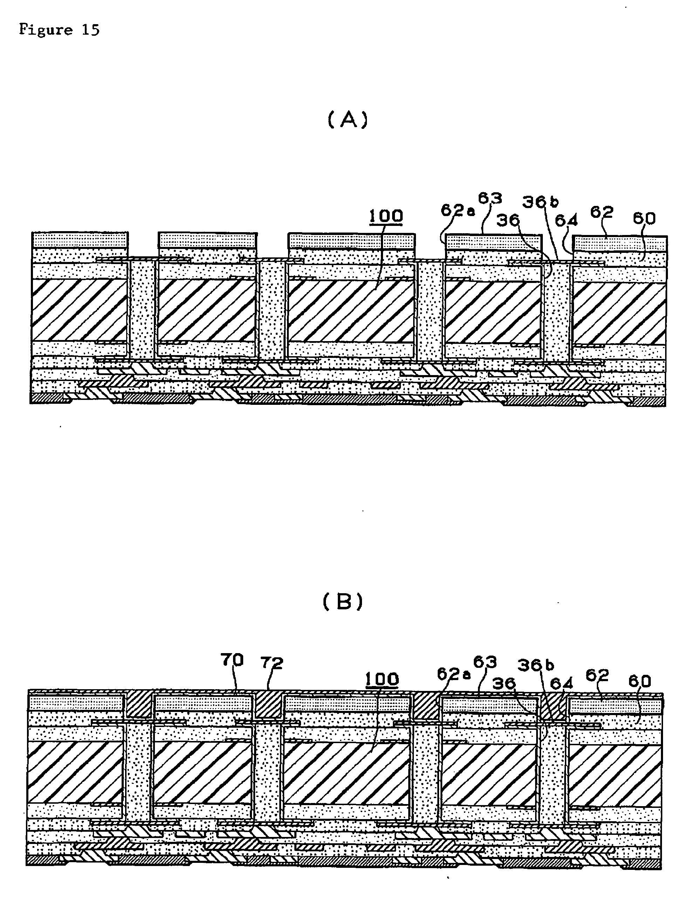

The method for manufacturing the substrate for mounting an IC chip pertaining to the fifth best mode in accordance with the present invention will be described with reference to Figs. 14 and 15.
In the fifth best mode, on the silicon substrate 62 provided with via holes 62a illustrated in Fig. 14 (A) there is formed an insulating film 63. The formation of this insulating film 63 is carried out by the thermal oxidation treatment at about 1,000°C performed on the silicon substrate 62, for example.
An insulating film may be formed by CVD in place of thermal oxidation treatment.

A silicon substrate 62 provided with via holes 62a and with the insulating film 63 being formed thereon is adhered to the multilayer build-up wiring board 100 (Fig. 14 (C)), and through holes 64 are bored into the low-elasticity resin layer 60 by laser via said via holes 62a (Fig. 15 (D)). Subsequently, as with the first best mode described above with reference to Fig. 2 (C) and Fig. 3 (A), an electroless-plated film 70 is formed by electroless plating on the surface of the silicon substrate 62 and on the through holes 64, and the electrolysis plating is carried out via the electroless-plated film 70 to fill the inside of the through holes 64 with electrolysis plating 72 (Fig. 15 (B)). The description of the subsequent steps is omitted since they are identical to those of the first best mode. The fifth best mode presents an advantage of an ease of processing.

### Industrial Applicability:

In the best modes described above, while a silicon substrate was used as a low-thermal-expansion substrate, a low-thermal-expansion substrate of a ceramic material, other than silicon, such as silicon nitride, silicon carbide, aluminum nitride, and mullite may also be used.

### Brief Description of the Drawings:

Fig. 1: Step views illustrating the method for manufacturing a substrate for mounting an IC chip in accordance with the first best mode in accordance with the present invention.
Fig. 2: Step views illustrating the method for manufacturing a substrate for mounting an IC chip in accordance with the first best mode.
Fig. 3: Step views illustrating the method for manufacturing a substrate for mounting an IC chip in accordance with the first best mode.
Fig. 4: Step views illustrating the method for manufacturing a substrate for mounting an IC chip in accordance with the first best mode.
Fig. 5: Step views illustrating the method for manufacturing a substrate for mounting an IC chip in accordance with the first best mode.
Fig. 6: Step views illustrating the method for manufacturing a substrate for mounting an IC chip in accordance with the first best mode.
Fig. 7: Step views illustrating the method for manufacturing a substrate for mounting an IC chip in accordance with the first best mode.
Fig. 8: A cross-sectional view of a substrate for mounting an IC chip pertaining to the first best mode.
Fig. 9: A cross-sectional view illustrating a substrate for mounting an IC chip illustrated in Fig. 8 with an IC chip disposed thereon.
Fig. 10: A cross-sectional view of a substrate for mounting an IC chip pertaining to the modified example of the first best mode.
Fig. 11: A cross-sectional view of a substrate for mounting an IC chip pertaining to the second best mode.
Fig. 12: A cross-sectional view of a substrate for mounting an IC chip pertaining to the third best mode.
Fig. 13: Step views illustrating the method for manufacturing a substrate for mounting an IC chip in accordance with the fourth best mode in accordance with the present invention.
Fig. 14: Step views illustrating the method for manufacturing a substrate for mounting an IC chip in accordance with the fifth best mode in accordance with the present invention.
Fig. 15: Step views illustrating the method for manufacturing a substrate for mounting an IC chip in accordance with the fifth best mode.

### Explanation of Reference Numerals:

- 10:: A substrate for mounting an IC chip
- 12:: An interlaminar resin insulating layer
- 16:: A via-hole conductor
- 18:: A conductor circuit
- 22:: An interlaminar resin insulating layer
- 26:: A via-hole conductor
- 28:: A conductor circuit
- 30:: A core substrate
- 36:: A through hole
- 36b:: A conductor pad for mounting
- 60:: A low-elasticity resin layer
- 62:: A silicon substrate
- 62a:: A via hole
- 64:: A through hole
- 63:: An insulating film
- 66:: An insulating layer
- 74:: A through-hole conductor

## Claims

1. A substrate for mounting an IC chip (10) comprising;
a printed substrate (100) having the first build-up layer (37) wherein a conductor layer having the first conductor circuit (35) and a resin insulating layer (34) are laminated in an alternate fashion and in repetition;
a low-elasticity resin layer (60) formed, wherein a Young's modulus of the low-elasticity resin layer (60) at 30 °C is 10 MPa through 1 GPa, on one face of said printed substrate (100), on the conductor layer and the resin insulating layer (34) positioned on the outermost layer of the above-described first build-up layer (37);
a low-thermal-expansion substrate (62) formed of ceramics or silicon and formed on said low-elasticity resin layer (60);
a through-hole conductor(74) running through said low-thermal-expansion substrate (62) and the above-described low-elasticity resin layer (60); and
the second conductor circuit (75) formed on one face of the above-described low-thermal-expansion substrate (62),
**characterized in that** the above-described through-hole conductor(74) being a through-hole filled by plating electrically connects the conductor layer positioned on the outermost layer of the above-described first build-up layer (37) and the second conductor circuit (75) on the above-described low-thermal-expansion substrate (62) without soldering.

2. A substrate for mounting an IC chip (10) as set forth in claim 1, wherein a second build-up layer (20) is formed wherein a conductor layer having a third conductor circuit (18) and an interlaminar resin insulating layer (12) are laminated in an alternate fashion and in repetition on the above-described low-thermal-expansion substrate (62) and on the second conductor circuit (75) on one face of the above-described low-thermal-expansion substrate (62).

3. A substrate for mounting an IC chip (10) as set forth in claim 2, wherein the pitch for the conductor layer positioned on the outermost layer of the above-described second build-up layer (20) is narrower than the pitch for the above-described through-hole conductor (74).

4. A substrate for mounting an IC chip (10) as set forth in claims 2 or 3, wherein the pitch for the conductor layer positioned at the lowermost layer of the above-described second build-up layer (20) is nearly identical to the pitch for the above-described through-hole conductor(74).

5. A substrate for mounting an IC chip (10) as set forth in either of claims 1 through 4, wherein the diameter of the through-holes (64) of the above-described low-thermal-expansion substrate (62) is smaller than the diameter of the conductor pads of the second conductor circuit (75) of the above-described low-thermal-expansion substrate (62).

6. A substrate for mounting an IC chip (10) as set forth in claim 1, wherein the above-described low-thermal-expansion substrate (62) is made of silicon.

7. A substrate for mounting an IC chip (10) as set forth in either of claims 1 through 6, wherein the above-described low-elasticity resin layer (60) is made of at least one composition selected from a group of resin compositions including epoxy resin, phenol resin crosslinking rubber particles and hardening catalyst.

8. A substrate for mounting an IC chip (10) as set forth in either of claims 1 through 7, wherein on the above-described low-thermal-expansion substrate (62) there is provided at least one of an L, a C, an R, and a VRM (a voltage regulator module).

9. A method of manufacturing a substrate for mounting an IC chip (10), comprising the following (a) through (f) steps:
(a) a step for laminating a low-thermal-expansion substrate (62) with a low-elasticity resin layer (60) being interposed on the printed substrate (100) having conductor pads for mounting (36b) on the outermost layer thereof ;
(b) a step for boring the first through holes (64) running through the above-described low-thermal-expansion substrate (62) and the above-described low-elasticity resin layer (60) and reaching the above-described conductor pads for mounting (36b) ;
(c) a step for filling insulating layers (66) inside the above-described through holes (64);
(d) a step for boring the second through holes (68) running through the above-described insulating layers (66) inside the above-described through holes (64) and reaching the above-described conductor pads for mounting (36b);
(e) a step for forming through-hole conductors (74) by providing plated layers inside the above-described second through holes (68); and
(f) a step for forming build-up wiring layers on the above-described low-thermal-expansion substrate (62).

10. A method of manufacturing a substrate for mounting an IC chip (10), comprising the following (a) through (f) steps:
(a) a step for laminating a low-thermal-expansion substrate (62) having via holes with a low-elasticity resin layer (60) being interposed on the printed substrate (100) having conductor pads for mounting (36b) on the outermost layer thereof; wherein a Young's modulus of the low-elasticity resin layer (60) at 30 °C is 10 MPa through 1 GPa;
(b) a step for boring the first through holes (64) running through the above-described low-elasticity resin layer (60) via the via holes of the above-described low-thermal-expansion substrate (62) and reaching the above-described conductor pads for mounting (36b);
(c) a step for filling insulating layers (66) inside the above-described through holes (64);
(d) a step for boring the second through holes (68) running through the above-described insulating layers (66) inside the above-described through holes (64) and reaching the above-described conductor pads for mounting (36b);
(e) a step for forming through-hole conductors (74) by providing plated layers inside the above-described second through holes (78); and
(f) a step for forming build-up wiring layers on the above-described low-thermal-expansion substrate (62).

11. A method of manufacturing a substrate for mounting an IC chip (10), comprising the following (a) through (d) steps:
(a) a step for laminating a low-thermal-expansion substrate (62) having via holes and with insulating films formed on the surface thereof with a low-elasticity resin layer (60) being interposed on the printed substrate (100) having conductor pads for mounting (36b) on the outermost layer thereof; wherein a Young's modulus of the low-elasticity resin layer (60) at 30°C is 10 MPa through 1 GPa;
(b) a step for boring the first through holes (64) running through the above-described low-elasticity resin layer (60) via the via holes of the above-described low-thermal-expansion substrate (62) and reaching the above-described conductor pads for mounting (36b);
(c) a step for forming through-hole conductors (74) by providing plated layers inside the above-described first through holes (64); and
(d) a step for forming build-up wiring layers on the above-described low-thermal-expansion substrate (62).

## Patentansprüche

1. Substrat zum Anbringen eines IC-Chips (10) mit:
einem bedruckten Substrat (100) mit einer ersten Aufbauschicht (37), bei der eine Leiterschicht mit dem ersten Leiterschaltkreis (35) und eine Harzisolierschicht (34) abwechselnd und wiederholt laminiert sind,
einer Harzschicht (60) mit einer niedrigen Elastizität, bei der ein Youngscher Modul der Harzschicht (60) mit einer niedrigen Elastizität bei 30°C im Bereich von 10 MPa bis 1 GPa liegt, die auf einer Fläche des bedruckten Substrats (100), auf der Leiterschicht und der Harzisolierschicht (34) ausgebildet ist, die an der äußersten Schicht der oben beschriebenen ersten Aufbauschicht (37) positioniert ist,
einem Substrat (62) mit einer niedrigen thermischen Ausdehnung, das aus Keramik oder Silizium ("silicon") ausgebildet ist und das auf der Harzschicht (60) mit einer niedrigen Elastizität ausgebildet ist,
einem Durchgangslochleiter (74), welcher durch das Substrat (62) mit einer niedrigen thermischen Ausdehnung und die oben beschriebene Harzschicht (60) mit einer niedrigen Elastizität verläuft und
dem zweiten Leiterschaltkreis (75) auf einer Fläche des oben beschriebenen Substrats (62) mit einer niedrigen thermischen Ausdehnung ausgebildet,
**dadurch gekennzeichnet, dass** der oben beschriebene Durchgangslochleiter (74) ein Durchgangsloch ist, das durch Plattierung angefüllt ist, welche die Leiterschicht, die auf der äußersten Schicht der oben beschriebenen ersten Aufbauschicht (37) positioniert ist, und den zweiten Leiterschaltkreis (75) auf dem Substrat (62) mit einer niedrigen thermischen Leitfähigkeit elektrisch ohne Löten verbindet.

2. Substrat zum Anbringen eines IC-Chips (10) nach Anspruch 1, bei dem eine zweite Aufbauschicht (20) ausgebildet ist, bei der eine Leiterschicht mit einem dritten Leiterschaltkreis (18) und eine Zwischenlagenharzisolierschicht (12) abwechselnd und wiederholt auf dem oben beschriebenen Substrat (62) mit einer niedrigen thermische Ausdehnung und auf dem zweiten Leiterschaltkreis (75) auf einer Fläche des oben beschriebenen Substrats (62) mit einer niedrigen thermischen Ausdehnung laminiert sind.

3. Substrat zum Anbringen eines IC-Chips (10) nach Anspruch 2, bei dem die Versetzung der Leiterschicht, die auf der äußersten Schicht der oben beschriebenen zweiten Aufbauschicht (20) angeordnet ist, schmaler ist als die Versetzung für den oben beschriebenen Durchgangslochleiter (74).

4. Substrat zum Anbringen eines IC-Chips (10) nach Anspruch 2 oder 3, bei dem die Versetzung für die Leiterschicht, die auf der untersten Schicht der oben beschriebenen zweiten Aufbauschicht (20) positioniert ist, nahezu identisch zu dem Abstand für den oben beschriebenen Durchgangslochleiter (74) ist.

5. Substrat zum Anbringen eines IC-Chips (10) nach einem der Ansprüche 1 bis 4, bei dem der Durchmesser der Durchgangslöcher (64) des oben beschriebenen Substrats (62) mit einer niedrigen thermischen Ausdehnung geringer ist als der Durchmesser der Leiterflächen des zweiten Leiterschaltkreises (75) des oben beschriebenen Substrats (62) mit einer niedrigen thermischen Ausdehnung.

6. Substrat zum Anbringen eines IC-Chips (10) nach Anspruch 1, bei dem das oben beschriebene Substrat (62) mit einer niedrigen thermischen Ausdehnung aus Silizium ("silicon") hergestellt ist.

7. Substrat zum Anbringen eines IC-Chips (10) nach einem der Ansprüche 1 bis 6, bei dem die oben beschriebene Harzschicht (60) mit einer niedrigen Elastizität aus wenigstens einer Zusammensetzung hergestellt ist, die aus einer Gruppe an Harzzusammensetzungen ausgewählt ist, welche Epoxydharz, Gummipartikel, die Phenolharz vercrosslinken, und einen Härtungskatalysator aufweisen.

8. Substrat zum Anbringen eines IC-Chips (10) nach einem der Ansprüche 1 bis 7, bei dem auf dem oben beschriebenen Substrat (62) mit einer niedrigen thermischen Ausdehnung wenigstens ein L, ein C, ein R und/oder ein VRM (Spannungsregulierungsmodul) vorgesehen sind.

9. Verfahren zum Herstellen eines Substrats zum Anbringen eines IC-Chips (10) mit den folgenden Schritten (a) bis (f):
(a) ein Schritt des Laminierens eines Substrats (62) mit einer niedrigen thermischen Ausdehnung mit einer Harzschicht (60) mit einer niedrigen Elastizität dazwischen eingefügt auf das bedruckte Substrat (100) mit Leiterflächen zum Anbringen (36b) an der äußersten Schicht von dieser, wobei ein Youngscher Modul der Harzschicht (60) mit einer niedrigen Elastizität bei 30°C im Bereich von 10 MPa bis 1 GPa liegt,
(b) ein Schritt des Bohrens der ersten Durchgangslöcher (64), welche durch das oben beschriebene Substrat (62) mit einer niedrigen thermischen Ausdehnung und die oben beschriebene Harzschicht (60) mit einer niedrigen Elastizität verlaufen und welche die oben beschriebenen Leiterflächen zum Anbringen (36b) erreichen,
(c) ein Schritt des Füllens von Isolierschichten (66) in die oben beschriebenen Durchgangslöcher (64),
(d) ein Schritt des Bohrens der zweiten Durchgangslöcher (68), welche durch die oben beschriebenen Isolierschichten (66) innerhalb der oben beschriebenen Durchgangslöcher (64) verlaufen und welche die oben beschriebenen Leiterflächen zum Anbringen (36b) erreichen,
(e) ein Schritt des Ausbildens von Durchgangslochleitern (74) durch das Bereitstellen von plattierten Schichten innerhalb der oben beschriebenen zweiten Durchgangslöcher (68) und
(f) ein Schritt des Ausbildens von Aufbauverdrahtungsschichten auf dem oben beschriebenen Substrat (62) mit einer niedrigen thermischen Ausdehnung.

10. Verfahren zum Herstellen eines Substrats zum Anbringen eines IC-Chips (10) mit den folgenden Schritten (a) bis (f):
(a) ein Schritt des Laminierens eines Substrats (62) mit einer niedrigen thermischen Ausdehnung mit Durchkontaktierungslöchern mit einer Harzschicht (60) mit einer niedrigen Elastizität dazwischen eingefügt auf das bedruckte Substrat (100) mit Leiterflächen zum Anbringen (36b) an der äußersten Schicht von dieser, wobei ein Youngscher Modul der Harzschicht (60) mit einer niedrigen Elastizität bei 30°C im Bereich von 10 MPa bis 1 GPa liegt,
(b) ein Schritt des Bohrens der ersten Durchgangslöcher (64), welche durch die oben beschriebene Harzschicht (60) mit einer niedrigen Elastizität verlaufen, durch die Durchkontaktierungslöcher des oben beschriebenen Substrats (62) mit einer niedrigen thermischen Ausdehnung und welche die oben beschriebenen Leiterflächen zum Anbringen (36b) erreichen,
(c) ein Schritt des Füllens von Isolierschichten (66) in die oben beschriebenen Durchgangslöcher (64),
(d) ein Schritt des Bohrens der zweiten Durchgangslöcher (68, welche durch die oben beschriebenen Isolierschichten (66) innerhalb der oben beschriebenen Durchgangslöcher (64) verlaufen und welche die oben beschriebenen Leiterflächen zum Anbringen (36b) erreichen,
(e) ein Schritt des Ausbildens von Durchgangslochleitern (74) durch das Bereitstellen von plattierten Schichten innerhalb der oben beschriebenen zweiten Durchgangslöcher (78) und
(f) ein Schritt des Ausbildens von Aufbauverdrahtungsschichten auf dem oben beschriebenen Substrat (62) mit einer niedrigen thermischen Ausdehnung.

11. Verfahren zum Herstellen eines Substrats zum Anbringen eines IC-Chips (10) mit folgenden Schritten (a) bis (d) :
(a) ein Schritt des Laminierens eines Substrats (62) mit einer niedrigen thermischen Ausdehnung mit Durchkontaktierungslöchern und mit einem Isolierfilm, der auf der Oberfläche von diesem ausgebildet ist, mit einer Harzschicht (60) mit einer niedrigen Elastizität dazwischen eingefügt auf das bedruckte Substrat (100) mit Leiterflächen zum Anbringen (36b) an der äußersten Schicht von dieser, wobei ein Youngscher Modul der Harzschicht (60) mit einer niedrigen Elastizität bei 30°C im Bereich von 10 MPa bis 1 GPa liegt,
(b) ein Schritt des Bohrens der ersten Durchgangslöcher (64), welche durch die oben beschriebene Harzschicht (60) mit einer niedrigen Elastizität verlaufen, durch die Durchkontaktierungslöcher des oben beschriebenen Substrats (62) mit einer niedrigen thermischen Ausdehnung und welche die oben beschriebenen Leiterflächen zum Anbringen (36b) erreichen,
(c) ein Schritt des Ausbildens von Durchgangslochleitern (74) durch das Bereitstellen von plattierten Schichten in den oben beschriebenen ersten Durchgangslöchern (64) und
(d) ein Schritt des Ausbildens von Aufbauverdrahtungsschichten auf dem oben beschriebenen Substrat (62) mit einer niedrigen thermischen Ausdehnung.

## Revendications

1. Substrat de montage d'une puce de CI (10) comprenant :
un substrat imprimé (100) ayant la première couche de surépaisseur (37) dans laquelle une couche conductrice ayant le premier circuit conducteur (35) et une couche isolante de résine (34) sont stratifiées d'une façon alternée et en répétition ;
une couche de résine à faible élasticité (60) formée, dans laquelle un module de Young de la couche de résine à faible élasticité (60) à 30 °C est de 10 MPa à 1 GPa, sur une face particulière dudit substrat imprimé (100), sur la couche conductrice et la couche isolante de résine (34) positionnées sur la couche la plus éloignée de la première couche de surépaisseur précédemment décrite (37) ;
un substrat à faible dilatation thermique (62) formé de céramique ou de silicium et formé sur ladite couche de résine à faible élasticité (60) ;
un conducteur à trou traversant (74) traversant ledit substrat à faible dilatation thermique (62) et la couche de résine à faible élasticité précédemment décrite (60) ; et
le deuxième circuit conducteur (75) formé sur une face particulière du substrat à faible dilatation thermique précédemment décrit (62),
**caractérisé en ce que** le conducteur à trou traversant précédemment décrit (74) est un trou traversant rempli par placage relie électriquement la couche conductrice positionnée sur la couche la plus éloignée de la première couche de surépaisseur précédemment décrite (37) et le deuxième circuit conducteur (75) sur le substrat à faible dilatation thermique précédemment décrit (62) sans soudure.

2. Substrat de montage d'une puce de CI (10) selon la revendication 1, dans lequel une seconde couche de surépaisseur (20) est formée dans laquelle une couche conductrice ayant un troisième circuit conducteur (18) et une couche isolante de résine interlaminaire (12) sont stratifiées d'une façon alternée et en répétition sur le substrat à faible dilatation thermique précédemment décrit (62) et sur le deuxième circuit conducteur (75) sur une face particulière du substrat à faible dilatation thermique précédemment décrit (62).

3. Substrat de montage d'une puce de CI (10) selon la revendication 2, dans lequel le pas pour la couche conductrice positionnée sur la couche la plus éloignée de la seconde couche de surépaisseur précédemment décrite (20) est plus étroit que le pas pour le conducteur à trou traversant précédemment décrit (74).

4. Substrat de montage d'une puce de CI (10) selon les revendications 2 ou 3, dans lequel le pas pour la couche conductrice positionnée au niveau de la couche la plus basse de la seconde couche de surépaisseur précédemment décrite (20) est presque identique au pas pour le conducteur à trou traversant précédemment décrit (74).

5. Substrat de montage d'une puce de CI (10) selon l'une ou l'autre des revendications 1 à 4, dans lequel le diamètre des trous traversants (64) du substrat à faible dilatation thermique précédemment décrit (62) est plus petit que le diamètre des plages de connexion conductrices du deuxième circuit conducteur (75) du substrat à faible dilatation thermique précédemment décrit (62).

6. Substrat de montage d'une puce de CI (10) selon la revendication 1, dans lequel le substrat à faible dilatation thermique précédemment décrit (62) est fait de silicium.

7. Substrat de montage d'une puce de CI (10) selon l'une quelconque des revendications précédentes 1 à 6, dans lequel la couche de résine à faible élasticité précédemment décrite (60) est faite d'au moins une composition sélectionnée à partir d'un groupe de compositions de résine incluant une résine époxy, une résine phénolique à particules de caoutchouc réticulantes et un catalyseur de durcissement.

8. Substrat de montage d'une puce de CI (10) selon l'une quelconque des revendications 1 à 7, dans lequel sur le substrat à faible dilatation thermique précédemment décrit (62) on dispose au moins l'un d'une L, d'un C, d'une R et d'un VRM (module régulateur de tension).

9. Procédé de fabrication d'un substrat de montage d'une puce de CI (10), comprenant les étapes (a) à (f) suivantes :
(a) une étape pour stratifier un substrat à faible dilatation thermique (62), une couche de résine à faible élasticité (60) étant interposée sur le substrat imprimé (100) ayant des plages de connexion conductrices pour montage (36b) sur la couche la plus éloignée de ce dernier, dans lequel un module de Young de la couche de résine à faible élasticité (60) à 30 °C est de 10 MPa à 1 GPa ;
(b) une étape pour forer les premiers trous traversants (64) traversant le substrat à faible dilatation thermique précédemment décrit (62) et la couche de résine à faible élasticité précédemment décrite (60) et atteindre les plages de connexion conductrices précédemment décrites pour le montage (36b) ;
(c) une étape pour charger des couches isolantes (66) à l'intérieur des trous traversants précédemment décrits (64) ;
(d) une étape pour forer les seconds trous traversants (68) traversant les couches d'isolation précédemment décrites (66) à l'intérieur des trous traversants précédemment décrits (64) et atteindre les plages de connexion conductrices précédemment décrites pour le montage (36b) ;
(e) une étape pour former des conducteurs à trou traversant (74) en réalisant des couches plaquées à l'intérieur des seconds trous traversants précédemment décrits (68) ; et
(f) une étape pour former des couches de câblage de surépaisseur sur le substrat à faible dilatation thermique précédemment décrit (62).

10. Procédé de fabrication d'un substrat de montage d'une puce de CI (10), comprenant les étapes (a) à (f) suivantes :
(a) une étape pour stratifier un substrat à faible dilatation thermique (62) ayant des trous d'interconnexion, une couche de résine à faible élasticité (60) étant interposée sur le substrat imprimé (100) ayant des plages de connexion conductrices pour le montage (36b) sur la couche la plus éloignée de ce dernier ; dans lequel un module de Young de la couche de résine à faible élasticité (60) à 30 °C est de 10 MPa à 1 GPa ;
(b) une étape pour forer les premiers trous traversants (64) traversant la couche de résine à faible élasticité précédemment décrite (60) via les trous d'interconnexion du substrat à faible dilatation thermique précédemment décrit (62) et atteindre les plages de connexion conductrices précédemment décrites pour le montage (36b) ;
(c) une étape pour charger des couches isolantes (66) à l'intérieur les trous traversants précédemment décrits (64) ;
(d) une étape pour forer les seconds trous traversants (68) traversant les couches isolantes précédemment décrites (66) à l'intérieur des trous traversants précédemment décrits (64) et atteindre les plages de connexion conductrices précédemment décrites pour le montage (36b) ;
(e) une étape pour former des conducteurs à trou traversant (74) en réalisant des couches plaquées à l'intérieur des seconds trous traversants précédemment décrits (78) ; et
(f) une étape pour former des couches de câblage de surépaisseur sur le substrat à faible dilatation thermique précédemment décrit (62).

11. Procédé de fabrication d'un substrat de montage d'une puce de CI (10), comprenant les étapes (a) à (d) suivantes :
(a) une étape pour stratifier un substrat à faible dilatation thermique (62) ayant des trous d'interconnexion et des films isolants formés sur la surface de ce dernier, une couche de résine à faible élasticité (60) étant interposée sur le substrat imprimé (100) ayant des plages de connexion conductrices pour le montage (36b) sur la couche la plus éloignée de ce dernier ; dans lequel le module de Young de la couche de résine à faible élasticité (60) à 30 °C est de 10 MPa à 1 GPa ;
(b) une étape pour forer les premiers trous traversants (64) traversant la couche de résine à faible élasticité précédemment décrite (60) via les trous d'interconnexion du substrat à faible dilatation thermique précédemment décrit (62) et atteindre les plages de connexion conductrices précédemment décrites pour le montage (36b) ;
(c) une étape pour former des conducteurs à trou traversant (74) en réalisant des couches plaquées à l'intérieur des premiers trous traversants précédemment décrits (64) ; et
(d) une étape pour former des couches de câblage de surépaisseur sur le substrat à faible dilatation thermique précédemment décrit (62).
